(19) Europäisches Patentamt
European Patent Office
Office européen des brevets

(11) **EP 3 813 215 B1**

(12) **EUROPÄISCHE PATENTSCHRIFT**

(45) Veröffentlichungstag und Bekanntmachung des Hinweises auf die Patenterteilung:
**22.06.2022   Patentblatt 2022/25**

(21) Anmeldenummer: **19205359.3**

(22) Anmeldetag: **25.10.2019**

(51) Internationale Patentklassifikation (IPC):
**H02H 3/40** *(2006.01)*   **G01R 31/08** *(2020.01)*
**H02H 1/00** *(2006.01)*   **H02H 1/04** *(2006.01)*

(52) Gemeinsame Patentklassifikation (CPC):
**H02H 3/40;** H02H 1/0092; H02H 1/04

(54) **VERFAHREN UND EINRICHTUNG ZUM ERZEUGEN EINES EINE ELEKTRISCHE IMPEDANZ KLASSIFIZIERENDEN KLASSIFIZIERUNGSSIGNALS**

METHOD AND DEVICE FOR PRODUCING A CLASSIFICATION SIGNAL CLASSIFYING AN ELECTRICAL IMPEDANCE

PROCÉDÉ ET DISPOSITIF DE PRODUCTION D'UN SIGNAL DE CLASSIFICATION D'UNE IMPÉDANCE ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**28.04.2021   Patentblatt 2021/17**

(73) Patentinhaber: **Siemens Aktiengesellschaft 80333 München (DE)**

(72) Erfinder:
• **Blumschein, Jörg 14165 Berlin (DE)**
• **Yelgin, Yilmaz 13589 Berlin (DE)**

(56) Entgegenhaltungen:
DE-A1- 4 100 646    DE-C1- 19 746 719

EP 3 813 215 B1

**Beschreibung**

Die Erfindung liegt auf dem Gebiet der Elektrotechnik und bezieht sich unter anderem auf ein Verfahren zum Erzeugen eines eine elektrische Impedanz klassifizierenden Klassifizierungssignals.

Bekanntermaßen lassen sich elektrische Leitungen und Netzabschnitte auf einen Kurzschluss hin überwachen, indem die an den Leitungen anliegenden Impedanzen gemessen werden. Wird dabei festgestellt, dass Impedanzwerte vorgegebene Auslösebedingungen erfüllen, beispielsweise in der komplexen Ebene in definierten Auslösegebieten liegen, so wird ein Auslösesignal erzeugt, mit dem einzelne Leitungen oder Leitungsabschnitte abgeschaltet werden. Derartige Überwachungen lassen sich beispielsweise mit sogenannten Distanzschutzeinrichtungen durchführen, wie sie unter anderem in den Schutzgeräten der Siemens AG der Baureihen SIPROTEC 7SA61 oder SIPROTEC 7SA82/86/87 implementiert sind.

Auch ist bekannt, dass sich bei elektrischen Energieverteil- bzw. Energieversorgungsnetzen an elektrischen Leitungen gemessene elektrische Impedanzen aufgrund von Netzschwankungen bzw. instabilen Netzsituationen zum Beispiel im Falle von Lastschwankungen oder abrupten Änderungen der Einspeisesituation zeitlich verändern können und deren komplexe Impedanzwerte - in der komplexen Ebene betrachtet - sogenannte Pendelbewegungen durchführen.

Im Falle von Pendelbewegungen ist es nachteilig, wenn - ohne dass tatsächlich ein abzuschaltender Kurzschluss vorliegt - die o. g. Distanzschutzeinrichtungen einen Fehler detektieren und Leitungen oder Leitungsabschnitte abschalten, weil dadurch die bereits problematische Netzsituation noch weiter verschärft und die Instabilität des Netzes noch weiter erhöht werden würde.

Wünschenswert ist es daher, im Falle von Pendelbewegungen Distanzschutzeinrichtungen sperren zu können, solange während des Pendelns kein Kurzschluss vorliegt, und wieder zu entsperren, wenn die Pendelbewegung beendet ist und/oder ein Kurzschluss aufgetreten sein könnte. Ein Verfahren zum Sperren und Entsperren von Distanzschutzeinrichtungen während Pendelbewegungen ist beispielsweise aus der Europäischen Patentschrift EP 2 304 857 B1 bekannt. Andere Verfahren zur Fehlererkennung auf Basis von Impedanzkurven sind in den folgenden Dokumenten offenbart: DE19746719C1 und DE4100646A1.

Der Erfindung liegt mit Blick auf die obige Problematik die Aufgabe zugrunde, ein Verfahren und eine Einrichtung anzugeben, die eine Klassifizierung von Impedanzbewegungen ermöglicht.

Diese Aufgabe wird erfindungsgemäß mit einem Verfahren mit den Merkmalen gemäß Patentanspruch 1 gelöst. Vorteilhafte Ausgestaltungen des erfindungsgemäßen Verfahrens sind in Unteransprüchen angegeben.

Danach ist erfindungsgemäß vorgesehen, dass der zeitliche Verlauf einer Impedanz unter Bildung von Impedanzwerten gemessen wird, mit zeitlich aufeinander folgenden Impedanzwerten Impedanzänderungsvektoren gebildet werden, deren Richtung die Bewegung der Impedanz in der komplexen Impedanzebene und deren Länge den Betrag der jeweiligen Impedanzänderung beschreibt, anhand der Impedanzwerte und/oder der Impedanzänderungsvektoren geprüft wird, ob die Impedanz gemäß zumindest einem vorgegebenen Bewegungskriterium eine gerichtete kontinuierliche Impedanzbewegung zeigt, im Falle einer zuvor erkannten, gerichteten kontinuierlichen Impedanzbewegung und im Falle eines nachfolgend erkannten Richtungswechsels der Impedanzbewegung auf das Erreichen eines Umkehrpunkts geschlossen wird und die Drehung der Impedanzänderungsvektoren im Bereich des Umkehrpunkts unter Bildung eines Drehwinkelmesswertes überwacht wird und ein einen Fehler anzeigendes Klassifizierungssignal erzeugt wird, wenn sich die Impedanzänderungsvektoren im Bereich des Umkehrpunkts um einen vorgegebenen Maximaldrehwinkel oder mehr als den vorgegebenen Maximaldrehwinkel gedreht haben.

Ein wesentlicher Vorteil des erfindungsgemäßen Verfahrens ist darin zu sehen, dass sich mit diesem sehr schnell Kurzschlüsse im Bereich von Umkehrpunkten bei Pendelbewegungen erkennen lassen. Bei Pendelbewegungen wechseln sich Pendelabschnitte, bei denen sich die Impedanzwerte gerichtet kontinuierlich bewegen und Umkehrabschnitte, bei denen sich die Bewegungsrichtung um ca. 180° dreht, ab. Im Bereich der Umkehrabschnitte verändern sich die Impedanzwerte betragsmäßig sehr langsam. Tritt nun im Bereich eines betragsmäßig niederohmigen Umkehrabschnitts ein Kurzschluss auf, so wird dieser unter Umständen keine signifikante Betragsänderung der Impedanz bewirken, so dass das kurzschlussbedingte Ende der Pendelbewegung erst erkannt wird, wenn die für ein Passieren eines Umkehrabschnitts übliche Zeitspanne (Umkehrpunktverweilphase) von ca. dreißig Netzperioden (also 600 ms bei einer Netzfrequenz von 50 Hz) veränderungslos abläuft und keine Wiederaufnahme einer gerichteten kontinuierliche Impedanzbewegung feststellbar ist. Mit anderen Worten würde - bei alleiniger Betrachtung der Impedanzbeträge - erst nach Ablauf der genannten Zeitspanne von ca. dreißig Netzperioden eine Fehlererkennung und beispielsweise eine Entsperrung einer zuvor gesperrten Distanzschutzeinrichtung möglich sein. An dieser Stelle setzt die Erfindung an, indem sie mit der erfindungsgemäß vorgesehenen Betrachtung der Impedanzänderungsvektoren im Bereich des Umkehrpunkts und der Überwachung der Drehung der Impedanzänderungsvektoren eine Fehlererkennung bzw. ein Ende der normalen Pendelbewegung bereits deutlich vor Ablauf der genannten Zeitspanne ermöglicht. Mit anderen Worten kann auf der Basis des erfindungsgemäß gebildeten Klassifizierungssignals beispielsweise eine Entsperrung einer Distanzschutzeinrichtung zeitlich noch während der Verweilphase im Bereich des Umkehrpunkts erfolgen, also noch lange bevor die übliche Umkehrpunktverweilphase von ca. dreißig Netzperioden abgelaufen ist.

Das einen Fehler anzeigende Klassifizierungssignal wird vorzugsweise als ein ein Ende einer Pendelbewegung anzeigendes Klassifizierungssignal aufgefasst, und es werden vorzugsweise bei Vorliegen des einen Fehler bzw. ein Ende einer Pendelbewegung anzeigenden Klassifizierungssignals zuvor vorgenommene Sperren von Schutzgeräten wieder aufgehoben.

Der vorgegebene Maximaldrehwinkel weist vorzugsweise einen Wert zwischen 240° und 310° auf und beträgt beispielsweise 270° ± 5°.

Das einen Fehler anzeigende Klassifizierungssignal wird vorzugsweise auch erzeugt, wenn nach Erreichen des Umkehrpunkts innerhalb einer vorgegebenen Zeitspanne keine Wiederaufnahme der gerichteten kontinuierlichen Impedanzbewegung gemäß dem zumindest einen vorgegebenen Bewegungskriterium festgestellt wird.

Die vorgegebene Zeitspanne beträgt vorzugsweise zwischen 20 und 40 Netzperioden der Netzfrequenz, mit der die elektrische Impedanz beaufschlagt ist.

Der Drehwinkelmesswert wird vorzugsweise ermittelt, indem jeweils der Winkel zwischen aufeinander folgenden Impedanzänderungsvektoren unter Bildung eines Winkelwerts ermittelt wird, und zwar unter Einschluss von Impedanzänderungsvektoren im Bereich gerichteter kontinuierlicher Impedanzbewegung vor dem Umkehrpunkt und Impedanzänderungsvektoren hinter dem Umkehrpunkt, und zwischen den aufeinander folgenden Winkelwerten Winkeldifferenzen ermittelt und die Beträge der Winkeldifferenzen addiert werden und die Summe der Beträge der Winkeldifferenzen als Drehwinkelmesswert weiterverwendet wird.

Auch ist es vorteilhaft, wenn im Falle einer erkannten gerichteten kontinuierlichen Impedanzbewegung ein eine Pendelbewegung anzeigendes Klassifizierungssignal erzeugt wird und das die Pendelbewegung anzeigende Klassifizierungssignal aufrechterhalten wird, es sei denn, dass sich die Impedanzänderungsvektoren im Bereich des Umkehrpunkts über den vorgegebenen Maximaldrehwinkel hinaus drehen oder nach Erreichen des Umkehrpunkts innerhalb der vorgegebenen Zeitspanne keine Wiederaufnahme der gerichteten kontinuierlichen Impedanzbewegung festgestellt wird.

Bezüglich der Umkehrpunkterkennung wird es als vorteilhaft angesehen, wenn die Beträge der Realteile zumindest dreier aufeinander folgender Impedanzänderungsvektoren unter Bildung einer Realteilsumme addiert werden und auf das Auftreten eines Richtungswechsels der Impedanzbewegung und auf das Erreichen eines Umkehrpunkts geschlossen wird, wenn der Betrag der Realteilsumme über ein vorgegebenes Maß hinaus von dem Betrag der Differenz zwischen dem Realteil des ersten zur Bildung der Realteilsumme herangezogenen Impedanzwerts und dem Realteil des letzten zur Bildung der Realteilsumme herangezogenen Impedanzwerts abweicht.

Alternativ oder zusätzlich kann in vorteilhafter Weise auf das Auftreten eines Richtungswechsels der Impedanzbewegung und auf das Erreichen eines Umkehrpunkts geschlossen werden, wenn die Realteile zweier aufeinander folgender Impedanzänderungsvektoren ungleiche Vorzeichen aufweisen.

Das vorgegebene Bewegungskriterium, anhand dessen geprüft wird, ob die Impedanz eine gerichtete kontinuierliche Impedanzbewegung zeigt, umfasst vorzugsweise eine Prüfung, ob der Betrag der zeitlichen Ableitung der Impedanzwerte nach der Zeit in einem vorgegebenen Sollintervall liegt.

Alternativ oder zusätzlich kann in vorteilhafter Weise vorgesehen sein, dass das vorgegebene Bewegungskriterium, anhand dessen geprüft wird, ob die Impedanz eine gerichtete kontinuierliche Impedanzbewegung zeigt, eine Prüfung umfasst, ob sich der Betrag der zeitlichen Ableitung des Realteils und/oder des Imaginärteils der Impedanz bei aufeinander folgenden Impedanzwerten über ein vorgegebenes Maß hinaus verändert oder nicht.

Alternativ oder zusätzlich kann in vorteilhafter Weise vorgesehen sein, dass das vorgegebene Bewegungskriterium, anhand dessen geprüft wird, ob die Impedanz eine gerichtete kontinuierliche Impedanzbewegung zeigt, eine Prüfung umfasst, ob die Winkeldifferenz zwischen den Impedanzänderungsvektoren zeitlich aufeinander folgender Impedanzänderungsvektoren eine vorgegebene Grenze über- oder unterschreitet.

Alternativ oder zusätzlich kann in vorteilhafter Weise vorgesehen sein, dass das vorgegebene Bewegungskriterium, anhand dessen geprüft wird, ob die Impedanz eine gerichtete kontinuierliche Impedanzbewegung zeigt, eine Prüfung umfasst, ob eine gleichzeitige Änderung sowohl des Vorzeichens des Realteils als auch des Vorzeichens des Imaginärteils bei zeitlich aufeinander folgenden Impedanzänderungsvektoren aufgetreten ist.

Die Erfindung bezieht sich außerdem auf ein Verfahren zum Steuern einer Schutzeinrichtung, insbesondere einer Distanzschutzeinrichtung, die eine Leitung, an die die elektrische Impedanz angeschlossen ist, überwacht. Erfindungsgemäß ist bezüglich eines solchen Verfahrens vorgesehen, dass die Schutzeinrichtung oder zumindest eine Schutzfunktion der Schutzeinrichtung zumindest auch unter Heranziehung eines Klassifizierungssignals gesteuert wird, das wie oben beschrieben erzeugt worden ist.

Die Schutzeinrichtung oder zumindest eine Schutzfunktion der Schutzeinrichtung wird vorzugsweise deaktiviert, solange das Klassifizierungssignal eine Pendelbewegung anzeigt.

Die Schutzeinrichtung oder zumindest eine Schutzfunktion der Schutzeinrichtung wird vorzugsweise aktiviert bzw. eine vorherige Sperre aufgehoben, wenn das Klassifizierungssignal einen Fehler, insbesondere ein Ende der Pendelbewegung, anzeigt.

Die Erfindung bezieht sich außerdem auf eine Einrichtung zum Erzeugen eines eine elektrische Impedanz klassifizierenden Klassifizierungssignals. Erfindungsgemäß ist bezüglich einer solchen Einrichtung vorgesehen, dass die Einrichtung derart ausgebildet ist, dass sie mit zeitlich aufeinander folgenden Impedanzwerten Impedanzänderungsvektoren bildet, deren Richtung die Bewegung der Impedanz in der komplexen Impedanzebene und deren Länge den Betrag der jeweiligen Impedanzänderung beschreibt, anhand der Impedanzwerte und/oder der Impedanzänderungsvektoren prüft, ob die Impedanz gemäß zumindest einem vorgegebenen Bewegungskriterium eine gerichtete kontinuierliche Impedanzbewegung zeigt, im Falle einer zuvor erkannten, gerichteten kontinuierlichen Impedanzbewegung und im Falle eines nachfolgend erkannten Richtungswechsels der Impedanzbewegung auf das Erreichen eines Umkehrpunkts schließt und die Drehung der Impedanzänderungsvektoren im Bereich des Umkehrpunkts unter Bildung eines Drehwinkelmesswertes überwacht und ein einen Fehler anzeigendes Klassifizierungssignal erzeugt, wenn sich die Impedanzänderungsvektoren im Bereich des Umkehrpunkts um einen vorgegebenen Maximaldrehwinkel oder mehr als den vorgegebenen Maximaldrehwinkel gedreht haben.

Bezüglich der Vorteile der erfindungsgemäßen Einrichtung und bezüglich vorteilhafter Ausgestaltungen der erfindungsgemäßen Einrichtung sei auf die obigen Ausführungen im Zusammenhang mit dem erfindungsgemäßen Verfahren und dessen vorteilhafter Ausgestaltungen verwiesen.

Vorteilhaft ist es, wenn die Einrichtung eine Schutzeinrichtung ist, die eine Recheneinrichtung und einen Speicher umfasst.

In dem Speicher sind vorzugsweise ein Pendelerkennungsmodul und ein Distanzschutzmodul abgespeichert. Das Pendelerkennungsmodul dient bei Ausführung durch die Recheneinrichtung vorzugsweise dazu, das Qualifizierungssignal zu erzeugen, das bei Vorliegen einer Pendelbewegung die Pendelung anzeigt und im Falle, dass ein vorgegebenes Winkelsummenkriterium nicht erfüllt wird, einen Fehler anzeigt. Wird ein Fehler angezeigt, wird eine vorherige Sperre des Distanzschutzmoduls während der Pendelbewegung vorzugsweise aufgehoben.

Die Erfindung wird nachfolgend anhand von Ausführungsbeispielen näher erläutert; dabei zeigen beispielhaft

Figur 1    eine Anordnung mit einer elektrischen Leitung, an die ein Ausführungsbeispiel für eine erfindungsgemäße Einrichtung in Form einer Schutzeinrichtung angeschlossen ist, wobei die Schutzeinrichtung dazu ausgebildet ist, ein Ausführungsbeispiel für das erfindungsgemäße Verfahren auszuführen,

Figur 2    ein Ausführungsbeispiel für ein erfindungsgemäßes Verfahren anhand eines Flussdiagramms,

Figur 3    ein Ausführungsbeispiel für eine vorteilhafte Prüfung auf das Vorliegen einer gerichteten kontinuierlichen Bewegung im Rahmen des Verfahrens gemäß Figur 2,

Figur 4    ein Ausführungsbeispiel für eine vorteilhafte Winkelprüfung im Rahmen des Verfahrens gemäß Figur 2,

Figur 5    ein beispielhafter Impedanzverlauf im Falle eines Kurzschlusses im Bereich eines Umkehrpunktes einer Pendelbewegung,

Figur 6    ein beispielhafter Impedanzverlauf bei einer Pendelbewegung ohne Kurzschluss im Bereich des Umkehrpunktes, und

Figur 7    eine Anordnung mit einer dreiphasigen elektrischen Leitung, an die ein weiteres Ausführungsbeispiel für eine erfindungsgemäße Einrichtung in Form einer Schutzeinrichtung angeschlossen ist.

In den Figuren werden der Übersicht halber für identische oder vergleichbare Komponenten stets dieselben Bezugszeichen verwendet.

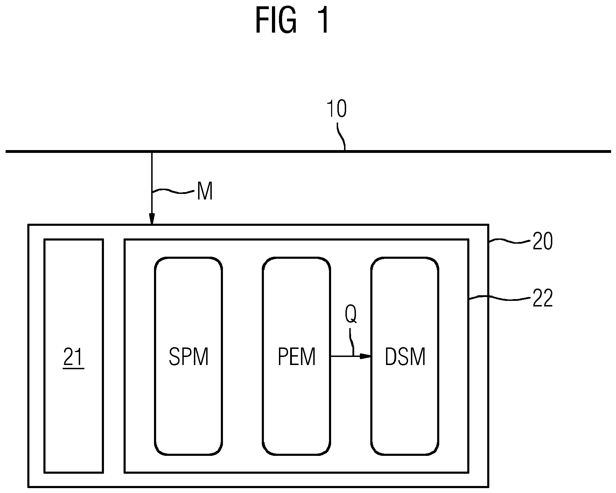

Die Figur 1 zeigt eine elektrische Leitung 10, an die ein Ausführungsbeispiel für eine erfindungsgemäße Einrichtung in Form einer Schutzeinrichtung 20 angeschlossen ist. Die Schutzeinrichtung 20 umfasst eine Recheneinrichtung 21 und einen Speicher 22.

In dem Speicher 22 sind unter anderem ein Steuerprogrammmodul SPM für die übergeordnete Funktionsweise der Schutzeinrichtung 20, beispielsweise für die Berechnung von Impedanzwerten oder Impedanzänderungsvektoren, ein Pendelerkennungsmodul PEM und ein Distanzschutzmodul DSM abgespeichert.

Das Pendelerkennungsmodul PEM dient bei Ausführung durch die Recheneinrichtung 21 dazu, ein Qualifizierungssignal Q zu erzeugen, das bei Vorliegen einer Pendelbewegung einer an der Leitung 10 anliegenden elektrischen Impedanz die Pendelung anzeigt und im Falle, dass ein vorgegebenes Winkelsummenkriterium nicht erfüllt wird, einen Fehler anzeigt.

Das Distanzschutzmodul DSM bildet bei Ausführung durch die Recheneinrichtung 21 eine Distanzschutzeinrichtung. Das Distanzschutzmodul DSM steht mit dem Pendelerkennungsmodul PEM in Verbindung und wird vorzugsweise bei Vorliegen eines Qualifizierungssignals, das eine Pendelung anzeigt, gesperrt, sodass das Distanzschutzmodul DSM unabhängig von anliegenden Impedanzwerten kein Auslösesignal erzeugen wird. Ist das Distanzschutzmodul DSM ungesperrt, so kann es die an der Leitung 10 anliegende Impedanz in bekannter Weise auswerten und ggf. ein Auslösesignal zum Abschalten der Leitung 10 erzeugen.

Zu der Schutzeinrichtung 20 gelangen Messwerte M. Die Messwerte M können Impedanzwerte sein, die die Impedanz an der elektrischen Leitung 10 unmittelbar angeben; alternativ kann es sich um andere Messwerte, wie beispielsweise Strommesswerte oder Spannungsmesswerte handeln, mit denen die Schutzeinrichtung 20 selbst Impedanzwerte bildet.

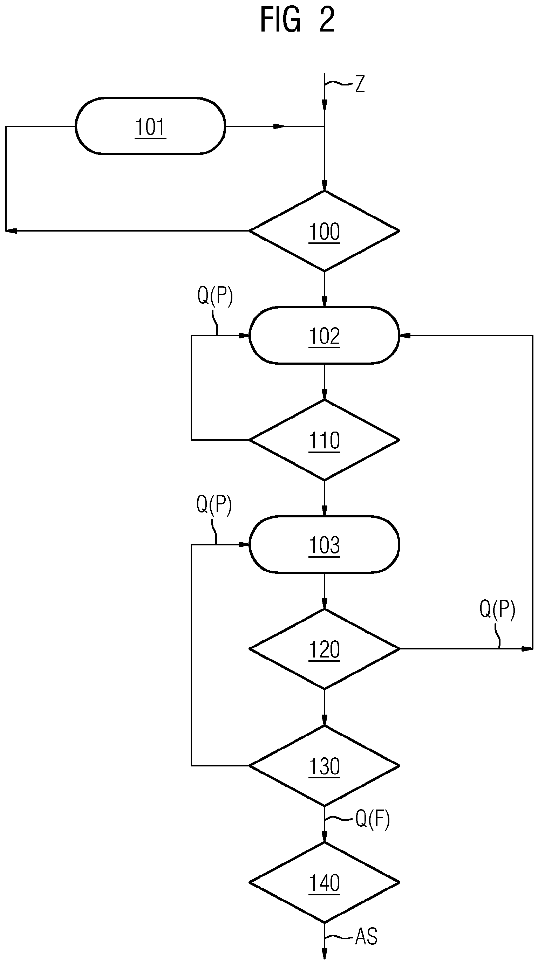

Die Arbeitsweise des Pendelerkennungsmoduls PEM und des Distanzschutzmoduls DSM gemäß Figur 1 wird nachfolgend anhand eines Flussdiagramms (siehe Figur 2) beispielhaft näher erläutert:

In einem Prüfschritt 100 wird zunächst geprüft, ob sich eingangsseitig anliegende komplexe Impedanzwerte Z kontinuierlich verändern bzw. in der komplexen Ebene eine kontinuierliche Bewegung zeigen. Auf eine kontinuierliche Bewegung im Unterschied beispielsweise zu einer sprunghaften Bewegung kann geschlossen werden, wenn der Betrag der Differenz zwischen aufeinander folgenden Impedanzwerten in einem vorgegebenen Sollintervall liegt, also mit anderen Worten der Betrag der zeitlichen Ableitung der Impedanzwerte nach der Zeit in diesem vorgegebenen Sollintervall liegt.

Wird eine Impedanzbewegung nicht erkannt, weil beispielsweise der Betrag der Differenz zwischen aufeinander folgenden Impedanzwerten Z zu klein ist, so wird eine Feststellung 101 getroffen, dass sich die Impedanz in der komplexen Ebene nicht bewegt.

Wird in dem Prüfschritt 100 hingegen festgestellt, dass sich die Impedanz kontinuierlich bewegt, so wird eine Feststellung 102 getroffen, dass eine kontinuierliche Impedanzbewegung stattfindet.

In einem nachfolgenden Prüfschritt 110 wird geprüft, ob sich die Impedanz gerichtet kontinuierlich bewegt. Ergibt der Prüfschritt 110 eine gerichtete kontinuierliche Impedanzbewegung, so bleibt es bei der Feststellung 102, dass sich die Impedanz bewegt. Außerdem wird ein Qualifizierungssignal Q(P) erzeugt, das eine Pendelbewegung P der Impedanz anzeigt. Durch das Qualifizierungssignal Q(P) wird das Distanzschutzmodul DSM gemäß Figur 1 vorzugsweise gesperrt.

Wird in dem Prüfschritt 110 hingegen festgestellt, dass sich die Impedanz nicht kontinuierlich gerichtet bewegt, so wird darauf geschlossen, dass sich die Impedanz womöglich an einem Umkehrpunkt einer Pendelbewegung befinden könnte. Es erfolgt in diesem Falle eine Feststellung 103, dass sich die Impedanz womöglich im Bereich eines Umkehrpunkts befindet.

In einem nachfolgenden Prüfschritt 120 wird bei Vorliegen der Feststellung 103 geprüft, ob die Impedanz innerhalb einer vorgegebenen Zeitspanne wieder eine gerichtete kontinuierliche Bewegung aufnimmt. Falls dies festgestellt wird, so wird wieder die Feststellung 102 getroffen, wonach sich die Impedanz bewegt. Außerdem wird das Qualifizierungssignal Q(P) aufrechterhalten, das eine Pendelbewegung P der Impedanz anzeigt.

Wird in dem Prüfschritt 120 hingegen festgestellt, dass sich die Impedanz im Bereich des Umkehrpunktes betragsmäßig nicht mehr signifikant verändert, so wird eine Winkelsummenprüfung 130 durchgeführt, bei der das Vorliegen eines vorgegebenen Winkelsummenkriteriums, das weiter unten noch näher erläutert wird, geprüft wird.

Wird bei der Winkelsummenprüfung 130 festgestellt, dass das Winkelsummenkriterium erfüllt wird, so wird wiederum die Feststellung 103 getroffen, dass sich die Impedanz am Umkehrpunkt einer Pendelung befindet. Das Qualifizierungssignal Q(P), das eine Pendelbewegung P der Impedanz anzeigt, bleibt aufrechterhalten.

Wird hingegen bei der Winkelsummenprüfung 130 festgestellt, dass das vorgegebene Winkelsummenkriterium nicht erfüllt wird, so wird ein Qualifizierungssignal Q(F) erzeugt, das auf einen Fehler F, insbesondere ein Ende der Pendelbewegung, hindeutet.

Liegt das Qualifikationssignal Q(F) vor, das einen Fehler anzeigt, so wird das Distanzschutzmodul DSM gemäß Figur 1 aktiviert bzw. die Blockade des Distanzschutzmoduls DSM aufgehoben, sodass nachfolgend das Distanzschutzmodul DSM eine Distanzschutzprüfung 140 vornehmen und gegebenenfalls ein Auslösesignal AS erzeugen kann. Die Distanzschutzprüfung 140 kann beispielsweise so durchgeführt werden, wie es vom Wikipedia Eintrag zu "Distanzschutzrelais" oder von den Schutzgeräten der Siemens AG der Baureihen SIPROTEC 7SA61 oder SIPROTEC 7SA82/86/87 bekannt ist.

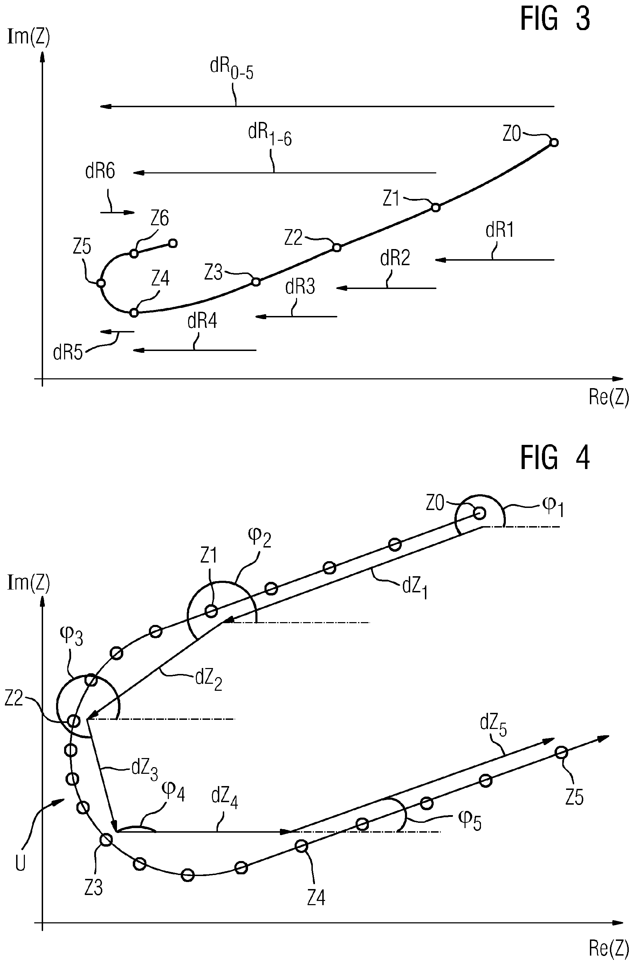

Die Figur 3 zeigt beispielhaft, wie der Prüfschritt 110 zur Prüfung auf das Vorliegen einer gerichteten kontinuierlichen Bewegung durchgeführt werden kann. Zu diesem Zweck zeigt die Figur 3 in der komplexen Ebene Impedanzwerte Z0 bis Z6, die zeitlich nacheinander gemessen worden sind.

Es lässt sich erkennen, dass bei den Impedanzwerten Z0 bis Z5 die Änderung des Realteils dR1 bis dR5 stets das gleiche Vorzeichen aufweist und somit eine mit den sechs Impedanzwerten Z0 bis Z5 betragsmäßig gebildete Realteilsumme aus den Realteiländerungen dR1, dR2,...,dR5 der Differenz $DR_{0-5}$ zwischen dem Realteil des ersten berücksichtigten Impedanzwerts Z0 und dem Realteil des sechsten berücksichtigten Impedanzwerts Z5 entspricht:

$$dR_{0-5} = \sum_{i=0}^{5} |dR_i|$$

Bei dem siebenten Impedanzwert Z6 verändert sich die Situation, weil die Impedanzbewegung bezüglich des Realteils einen Vorzeichenwechsel zeigt und somit beispielsweise eine mit den sechs Impedanzwerten Z1 bis Z6 betragsmäßig gebildete Realteilsumme der Differenz zwischen dem Realteil des ersten berücksichtigten Impedanzwerts Z1 und dem Realteil des siebenten berücksichtigten Impedanzwerts Z6 nicht mehr genau entspricht, sondern von dieser abweicht:

$$dR_{1-6} \quad \neq \quad \sum_{i=1}^{6} | dR_i |$$

bzw.

$$ABW \quad = \quad | dR_{1-6} - \sum_{i=1}^{6} | dR_i || \quad \neq \quad 0$$

Übersteigt die Abweichung ABW ein vorgegebenes Maß, so wird auf das Auftreten eines Richtungswechsels der Impedanzbewegung und auf das Erreichen eines Umkehrpunkts geschlossen.

Die Figur 4 zeigt beispielhaft, wie die Winkelsummenprüfung 130 gemäß Figur 2 durchgeführt werden kann. Die Figur 4 zeigt zu diesem Zweck in der komplexen Ebene einen Impedanzverlauf in der Nähe eines Umkehrpunktes U, an dem sich die Impedanzwerte Z kaum bewegen.

Wird der Stillstand der Impedanzbewegung beim Prüfschritt 120 erkannt, so wird im Rahmen der Winkelsummenprüfung 130 damit begonnen, eine Winkelsumme $\varphi s$ zu berechnen, die das Drehen der Impedanzänderungsvektoren dZ1 bis dZ5 im Bereich des Umkehrpunkts quantitativ beschreibt und demgemäß auch als Drehwinkelmesswert bezeichnet werden kann:

```
φs = |φ2-φ1| + |φ3-φ2| +|φ4-φ3| +|φ5-φ4|
```

```
φs = |-140°-(-160°)| + |-70°-(-140°)| + |0°-(-70°)| + |40°-
     (0°)| = 200°
```

Die Überprüfung der Winkelsumme bzw. des Drehwinkelmesswerts $\varphi s$ erfolgt, während der Impedanzverlauf sich in der Nähe des Umkehrpunktes U befindet und sich die Impedanz nicht signifikant weiterbewegt. Während einer synchronen Pendelung weist der Impedanzverlauf im Idealfall eine 180°-Drehung auf und geht anschließend wieder in eine gerichtete kontinuierliche Bewegung über, wie dies beispielhaft die Figur 4 zeigt. Der Drehwinkelmesswert $\varphi s$ wird in diesem Falle einen Wert von ca. 180 nicht wesentlich überschreiten.

Solange also eine für das Passieren eines Umkehrpunkts U während einer Pendelung typische Zeitspanne von beispielsweise 30 Netzperioden noch nicht abgelaufen ist und die Winkelsumme $\varphi s$ einen Wert von ca. 180 noch nicht wesentlich überschritten hat, wird bei der Winkelsummenprüfung 130 vorzugsweise weiterhin davon ausgegangen, dass eine Pendelung vorliegen kann, und es wird das Winkelsummenkriterium als erfüllt angesehen.

Kommt es hingegen im Bereich des Umkehrpunktes U zu einem Kurzschluss, so werden sich die Impedanzänderungsvektoren im Bereich des Umkehrpunkts U erfahrungsgemäß weiter drehen und einen vorgegebenen Maximaldrehwinkel von beispielsweise 270° erreichen oder überschreiten.

Demgemäß wird bei der Winkelsummenprüfung 130 das Winkelsummenkriterium nicht mehr als erfüllt angesehen, sobald die Impedanzänderungsvektoren im Bereich des Umkehrpunkts den vorgegebenen Maximaldrehwinkel von beispielsweise 270° erreicht haben.

Auch wird das Winkelsummenkriterium nicht mehr als erfüllt angesehen, sobald die für das Passieren eines Umkehrpunkts U während einer Pendelung typische Zeitspanne von beispielsweise 30 Netzperioden ergebnislos abgelaufen ist, also keine Wiederaufnahme einer gerichteten kontinuierlichen Bewegung der Impedanzwerte nach dem Erreichen des Umkehrpunkts U festgestellt wurde.

Der Vorteil der beschriebenen Prüfung von zwei Teilkriterien, nämlich der Wiederaufnahme einer gerichteten kontinuierlichen Bewegung innerhalb einer für Pendelungen typischen Zeitspanne von beispielsweise 30 Netzperioden in Kombination mit der zusätzlichen Winkelprüfung ermöglicht in vorteilhafter Weise das sehr schnelle Entsperren des Distanzschutzmoduls DSM bereits vor Ablauf der für Pendelungen typischen Zeitspanne, wenn die Winkelprüfung auf einen Fehler hindeutet.

Für die Berechnung der Winkelsumme $\varphi s$ wird vorzugsweise ein Messfenster von zumindest zwei Netzperioden verwendet, um Ausreißer in der Impedanzberechnung wegzuglätten.

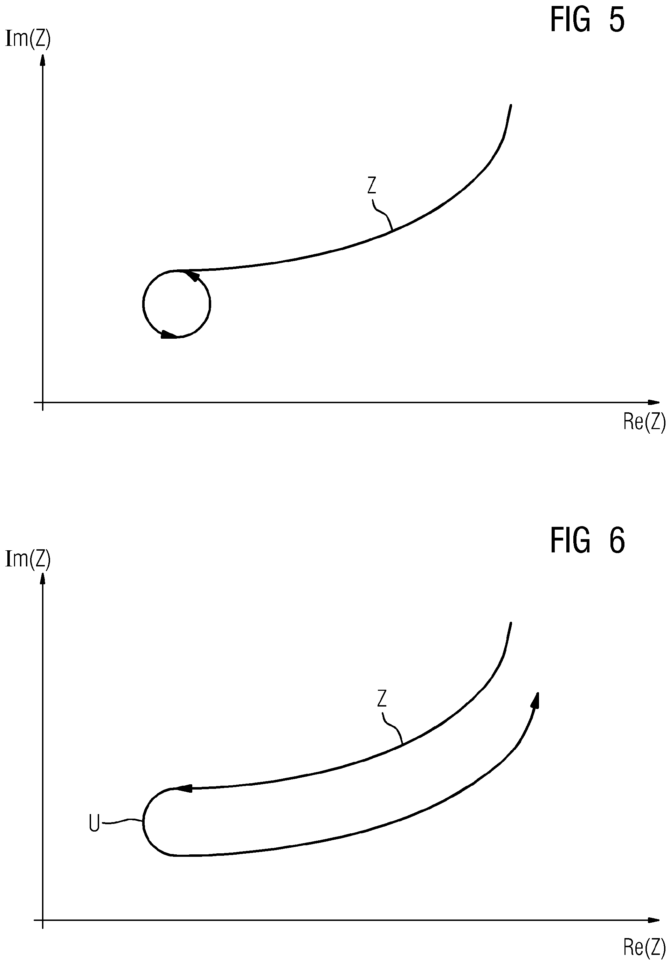

Die Figur 5 zeigt einen typischen Impedanzverlauf von Impedanzwerten Z bei Auftreten eines Kurzschlusses im Bereich eines Umkehrpunkts U während einer Pendelbewegung. Es lässt sich erkennen, dass sich die Impedanzvektoren eindrehen und den Maximaldrehwinkel überschreiten. Sobald dies mittels des Winkelsummenkriteriums erkannt wird, kann die Sperre des Distanzschutzmoduls DSM gemäß Figur 1 aufgehoben werden und es kann eine Distanzschutzprüfung durch das Distanzschutzmodul DSM erfolgen.

Die Figur 6 zeigt einen typischen Impedanzverlauf von Impedanzwerten Z ohne Auftreten eines Kurzschlusses im Bereich des Umkehrpunkts U während einer Pendelbewegung. Es lässt sich erkennen, dass die Impedanzwerte nach einer Drehung von ca. 180° wieder eine gerichtete kontinuierliche Bewegung aufnehmen. Geschieht dies innerhalb der typischen Zeitspanne von beispielsweise 30 Netzperioden, so wird die Sperre des Distanzschutzmoduls DSM gemäß Figur 1 vorzugsweise aufrechterhalten.

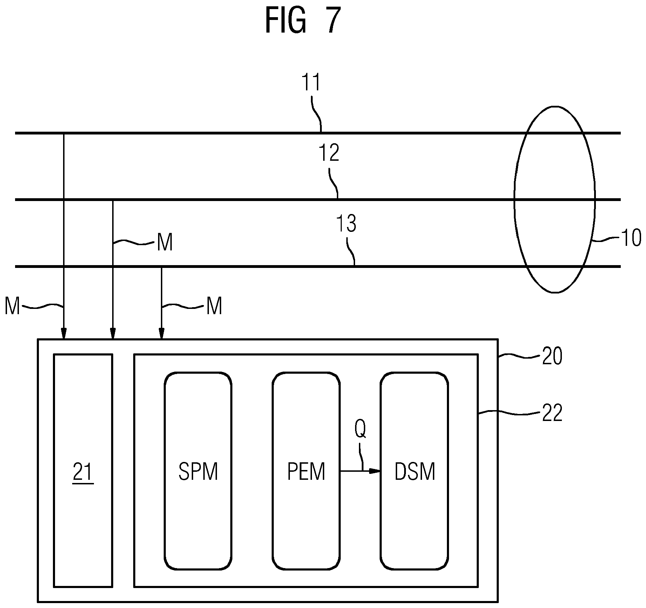

Die Figur 7 zeigt eine dreiphasige elektrische Leitung 10, an deren Phasenleiter 11, 12 und 13 eine Schutzeinrichtung 20 angeschlossen ist. Die Schutzeinrichtung 20 umfasst eine Recheneinrichtung 21 und einen Speicher 22, in dem unter anderem ein Pendelerkennungsmodul PEM und ein Distanzschutzmodul DSM abgespeichert sind. Die Schutzeinrichtung 20 arbeitet vorzugsweise bezüglich jedes der Phasenleiter 11, 12 und 13 jeweils so, wie dies im Zusammenhang mit der Figur 1 anhand einer einphasigen Leitung 10 erläutert wurde.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Bezugszeichenliste

| | |
|---|---|
| 10 | elektrische Leitung |
| 11 | Phasenleiter |
| 12 | Phasenleiter |
| 13 | Phasenleiter |
| 20 | Schutzeinrichtung |
| 21 | Recheneinrichtung |
| 22 | Speicher |
| 100 | Prüfschritt |
| 101 | Feststellung |
| 102 | Feststellung |
| 103 | Feststellung |
| 110 | Prüfschritt |
| 120 | Prüfschritt |
| 130 | Winkelsummenprüfung |
| 140 | Distanzschutzprüfung |

| | |
|---|---|
| ABW | Abweichung |
| AS | Auslösesignal |
| dR1-dR6 | Realteil |
| dZ1-dZ5 | Impedanzänderungsvektoren |
| $DR_{0-5}$ | Differenzwert |
| DSM | Distanzschutzmodul |
| F | Fehler |
| M | Messwerte |
| P | Pendelbewegung |
| PEM | Pendelerkennungsmodul |
| Q | Qualifizierungssignal |
| Q(F) | Qualifizierungssignal |
| Q(P) | Qualifizierungssignal |
| SPM | Steuerprogrammmodul |
| U | Umkehrpunkt |
| Z | Impedanzwerte |
| Z0-Z6 | Impedanzwerte |
| $\varphi1-\varphi5$ | Winkelwert |

φs        Winkelsumme / Drehwinkelmesswert

**Patentansprüche**

1. Verfahren zum Erzeugen eines eine elektrische Impedanz klassifizierenden Klassifizierungssignals (Q), **dadurch gekennzeichnet, dass**

   - der zeitliche Verlauf der Impedanz unter Bildung von Impedanzwerten (Z, Z0-Z6) gemessen wird,
   - mit zeitlich aufeinander folgenden Impedanzwerten (Z, Z0-Z6) Impedanzänderungsvektoren (dZ1-dZ5) gebildet werden, deren Richtung die Bewegung der Impedanz in der komplexen Impedanzebene und deren Länge den Betrag der jeweiligen Impedanzänderung beschreibt,
   - anhand der Impedanzwerte (Z, Z0-Z6) und/oder der Impedanzänderungsvektoren (dZ1-dZ5) geprüft wird, ob die Impedanz gemäß zumindest einem vorgegebenen Bewegungskriterium eine gerichtete kontinuierliche Impedanzbewegung zeigt,
   - im Falle einer zuvor erkannten, gerichteten kontinuierlichen Impedanzbewegung und im Falle eines nachfolgend erkannten Richtungswechsels der Impedanzbewegung auf das Erreichen eines Umkehrpunkts (U) geschlossen wird und die Drehung der Impedanzänderungsvektoren (dZ1-dZ5) im Bereich des Umkehrpunkts (U) unter Bildung eines Drehwinkelmesswertes (φs) überwacht wird und
   - ein einen Fehler (F) anzeigendes Klassifizierungssignal (Q) erzeugt wird, wenn sich die Impedanzänderungsvektoren (dZ1-dZ5) im Bereich des Umkehrpunkts (U) um einen vorgegebenen Maximaldrehwinkel oder mehr als den vorgegebenen Maximaldrehwinkel gedreht haben.

2. Verfahren nach Anspruch 1, **dadurch gekennzeichnet, dass** der vorgegebene Maximaldrehwinkel einen Wert zwischen 240° und 310° aufweist, insbesondere 270° $\pm$ 5° beträgt.

3. Verfahren nach einem der voranstehenden Ansprüche, **dadurch gekennzeichnet, dass** das einen Fehler (F) anzeigende Klassifizierungssignal (Q) auch dann erzeugt wird, wenn nach Erreichen des Umkehrpunkts (U) innerhalb einer vorgegebenen Zeitspanne keine Wiederaufnahme der gerichteten kontinuierlichen Impedanzbewegung gemäß dem zumindest einen vorgegebenen Bewegungskriterium festgestellt wird.

4. Verfahren nach Anspruch 3, **dadurch gekennzeichnet, dass** die vorgegebene Zeitspanne zwischen 20 und 40 Netzperioden der Netzfrequenz beträgt, mit der die elektrische Impedanz beaufschlagt ist.

5. Verfahren nach einem der voranstehenden Ansprüche, **dadurch gekennzeichnet, dass** der Drehwinkelmesswert (φs) ermittelt wird, indem

   - jeweils der Winkel zwischen aufeinander folgenden Impedanzänderungsvektoren (dZ1-dZ5) unter Bildung eines Winkelwerts (φ1-φ5) ermittelt wird, und zwar unter Einschluss von Impedanzänderungsvektoren (dZ1-dZ5) im Bereich gerichteter kontinuierlicher Impedanzbewegung vor dem Umkehrpunkt (U) und Impedanzänderungsvektoren (dZ1-dZ5) hinter dem Umkehrpunkt (U), und
   - zwischen den aufeinander folgenden Winkelwerten (φ1-φ5) Winkeldifferenzen (φ2-φ1, φ3-φ2, φ4-φ3, φ5-φ4) ermittelt und die Beträge der Winkeldifferenzen (|φ2-φ1|, |φ3-φ2|, |φ4-φ3|, |φ5-φ4|) addiert werden und die Summe der Beträge der Winkeldifferenzen als Drehwinkelmesswert weiterverwendet wird.

6. Verfahren nach einem der voranstehenden Ansprüche, **dadurch gekennzeichnet, dass**

   - im Falle einer erkannten gerichteten kontinuierlichen Impedanzbewegung ein eine Pendelbewegung (P) anzeigendes Klassifizierungssignal (Q) erzeugt wird und
   - das die Pendelbewegung (P) anzeigende Klassifizierungssignal (Q) aufrechterhalten wird, es sei denn, dass sich die Impedanzänderungsvektoren (dZ1-dZ5) im Bereich des Umkehrpunkts (U) über den vorgegebenen Maximaldrehwinkel hinaus drehen oder nach Erreichen des Umkehrpunkts (U) innerhalb der vorgegebenen Zeitspanne keine Wiederaufnahme der gerichteten kontinuierlichen Impedanzbewegung festgestellt wird.

**7.** Verfahren nach einem der voranstehenden Ansprüche,
**dadurch gekennzeichnet, dass**

- die Beträge der Realteile (dR1-dR5) zumindest dreier aufeinander folgender Impedanzänderungsvektoren (dZ1-dZ5) unter Bildung einer Realteilsumme addiert werden und
- auf das Auftreten eines Richtungswechsels der Impedanzbewegung und auf das Erreichen eines Umkehrpunkts (U) geschlossen wird, wenn der Betrag der Realteilsumme über ein vorgegebenes Maß hinaus von dem Betrag der Differenz zwischen dem Realteil des ersten zur Bildung der Realteilsumme herangezogenen Impedanzwerts (Z, Z0-Z6) und dem Realteil des letzten zur Bildung der Realteilsumme herangezogenen Impedanzwerts (Z, Z0-Z6) abweicht.

**8.** Verfahren nach einem der voranstehenden Ansprüche,
**dadurch gekennzeichnet, dass**
auf das Auftreten eines Richtungswechsels der Impedanzbewegung und auf das Erreichen eines Umkehrpunkts (U) geschlossen wird, wenn die Realteile zweier aufeinander folgender Impedanzänderungsvektoren (dZ1-dZ5) ungleiche Vorzeichen aufweisen.

**9.** Verfahren nach einem der voranstehenden Ansprüche,
**dadurch gekennzeichnet, dass**
das vorgegebene Bewegungskriterium, anhand dessen geprüft wird, ob die Impedanz eine gerichtete kontinuierliche Impedanzbewegung zeigt, eine Prüfung umfasst, ob der Betrag der zeitlichen Ableitung der Impedanzwerte (Z, Z0-Z6) nach der Zeit in einem vorgegebenen Sollintervall liegt.

**10.** Verfahren nach einem der voranstehenden Ansprüche,
**dadurch gekennzeichnet, dass**
das vorgegebene Bewegungskriterium, anhand dessen geprüft wird, ob die Impedanz eine gerichtete kontinuierliche Impedanzbewegung zeigt, eine Prüfung umfasst, ob sich der Betrag der zeitlichen Ableitung des Realteils und/oder des Imaginärteils der Impedanz bei aufeinander folgenden Impedanzwerten (Z, Z0-Z6) über ein vorgegebenes Maß hinaus verändert oder nicht.

**11.** Verfahren nach einem der voranstehenden Ansprüche,
**dadurch gekennzeichnet, dass**

- das vorgegebene Bewegungskriterium, anhand dessen geprüft wird, ob die Impedanz eine gerichtete kontinuierliche Impedanzbewegung zeigt, eine Prüfung umfasst, ob die Winkeldifferenz zwischen den Impedanzänderungsvektoren (dZ1-dZ5) zeitlich aufeinander folgender Impedanzänderungsvektoren (dZ1-dZ5) eine vorgegebene Grenze über- oder unterschreitet, und/oder
- das vorgegebene Bewegungskriterium, anhand dessen geprüft wird, ob die Impedanz eine gerichtete kontinuierliche Impedanzbewegung zeigt, eine Prüfung umfasst, ob eine gleichzeitige Änderung sowohl des Vorzeichens des Realteils als auch des Vorzeichens des Imaginärteils bei zeitlich aufeinander folgenden Impedanzänderungsvektoren (dZ1-dZ5) aufgetreten ist.

**12.** Verfahren zum Steuern einer Schutzeinrichtung, insbesondere einer Distanzschutzeinrichtung (DSM), die eine Leitung, an die die elektrische Impedanz angeschlossen ist, überwacht,
**dadurch gekennzeichnet, dass**
die Schutzeinrichtung oder zumindest eine Schutzfunktion der Schutzeinrichtung zumindest auch unter Heranziehung eines Klassifizierungssignals (Q) gesteuert wird, das nach einem der voranstehenden Ansprüche erzeugt worden ist.

**13.** Verfahren nach Anspruch 12,
**dadurch gekennzeichnet, dass**
die Schutzeinrichtung oder zumindest eine Schutzfunktion der Schutzeinrichtung deaktiviert wird, solange das Klassifizierungssignal (Q) eine Pendelbewegung (P) anzeigt.

**14.** Verfahren nach einem der voranstehenden Ansprüche 12 bis 13,
**dadurch gekennzeichnet, dass**
die Schutzeinrichtung oder zumindest eine Schutzfunktion der Schutzeinrichtung deaktiviert wird, wenn das Klassifizierungssignal (Q) einen Fehler (F) anzeigt.

**15.** Einrichtung (20) zum Erzeugen eines eine elektrische Impedanz klassifizierenden Klassifizierungssignals (Q),
**dadurch gekennzeichnet, dass**
die Einrichtung (20) derart ausgebildet ist, dass sie

- mit zeitlich aufeinander folgenden Impedanzwerten (Z, Z0-Z6) Impedanzänderungsvektoren (dZ1-dZ5) bildet, deren Richtung die Bewegung der Impedanz in der komplexen Impedanzebene und deren Länge den Betrag der jeweiligen Impedanzänderung beschreibt,
- anhand der Impedanzwerte (Z, Z0-Z6) und/oder der Impedanzänderungsvektoren (dZ1-dZ5) prüft, ob die Impedanz gemäß zumindest einem vorgegebenen Bewegungskriterium eine gerichtete kontinuierliche Impedanzbewegung zeigt,
- im Falle einer zuvor erkannten, gerichteten kontinuierlichen Impedanzbewegung und im Falle eines nachfolgend erkannten Richtungswechsels der Impedanzbewegung auf das Erreichen eines Umkehrpunkts (U) schließt und die Drehung der Impedanzänderungsvektoren (dZ1-dZ5) im Bereich des Umkehrpunkts (U) unter Bildung eines Drehwinkelmesswertes ($\varphi$s) überwacht und
- ein einen Fehler (F) anzeigendes Klassifizierungssignal (Q) erzeugt, wenn sich die Impedanzänderungsvektoren (dZ1-dZ5) im Bereich des Umkehrpunkts (U) um einen vorgegebenen Maximaldrehwinkel oder mehr als den vorgegebenen Maximaldrehwinkel gedreht haben.

## Claims

**1.** Method for generating a classification signal (Q) classifying an electrical impedance,
**characterized in that**

- the time characteristic of the impedance is measured with the formation of impedance values (Z, Z0-Z6),
- impedance change vectors (dZ1-dZ5) whose direction describes the movement of the impedance in the complex impedance plane and whose length describes the amount of the respective impedance change are formed with temporally successive impedance values (Z, Z0-Z6),
- a check is carried out on the basis of the impedance values (Z, Z0-Z6) and/or the impedance change vectors (dZ1-dZ5) to determine whether the impedance shows a directional, continuous impedance movement according to at least one predefined movement criterion,
- in the event of a previously detected directional, continuous impedance movement and in the event of a subsequently detected change of direction of the impedance movement, the reaching of a reversal point (U) is inferred and the rotation of the impedance change vectors (dZ1-dZ5) is monitored in the area of the reversal point (U) with formation of an angle of rotation measured value ($\varphi$s), and
- a classification signal (Q) indicating a fault (F) is generated if the impedance change vectors (dZ1-dZ5) have rotated in the area of the reversal point (U) through a predefined maximum angle of rotation or through more than the predefined maximum angle of rotation.

**2.** Method according to Claim 1,
**characterized in that**
the predefined maximum angle of rotation has a value between 240° and 310°, in particular is 270° $\pm$ 5°.

**3.** Method according to one of the preceding claims, **characterized in that**
the classification signal (Q) indicating a fault (F) is generated even if no resumption of the directional, continuous impedance movement according to the at least one predefined movement criterion is determined within a predefined time period after the reversal point (U) has been reached.

**4.** Method according to Claim 3,
**characterized in that**
the predefined time period is between 20 and 40 network periods of the network frequency applied to the electrical impedance.

**5.** Method according to one of the preceding claims, **characterized in that**
the angle of rotation measured value ($\varphi$s) is determined by

- determining the angle in each case between consecutive impedance change vectors (dZ1-dZ5) with formation of an angle value ($\varphi$1-$\varphi$5), including impedance change vectors (dZ1-dZ5) in the area of directional, continuous impedance movement in front of the reversal point (U) and impedance change vectors (dZ1-dZ5) behind the reversal point (U), and
- determining angle differences ($\varphi2$-$\varphi1$, $\varphi3$-$\varphi2$, $\varphi4$-$\varphi3$, $\varphi5$-$\varphi4$) between the consecutive angle values ($\varphi1$-$\varphi5$) and adding together the amounts of the angle differences ($|\varphi2$-$\varphi1|$, $|\varphi3$-$\varphi2|$, $|\varphi4$-$\varphi3|$, $|\varphi5$-$\varphi4|$) and further using the sum of the amounts of the angle differences as the angle of rotation measured value.

6. Method according to one of the preceding claims, **characterized in that**

- a classification signal (Q) indicating an oscillation movement (P) is generated in the event of a detected directional, continuous impedance movement, and
- the classification signal (Q) indicating the oscillation movement (P) is maintained unless the impedance change vectors (dZ1-dZ5) rotate beyond the predefined maximum angle of rotation in the area of the reversal point (U) or no resumption of the directional, continuous impedance movement is determined within the predefined time period after the reversal point (U) has been reached.

7. Method according to one of the preceding claims, **characterized in that**

- the amounts of the real components (dR1-dR5) of at least three consecutive impedance change vectors (dZ1-dZ5) are added together with formation of a real component sum, and
- the occurrence of a change of direction of the impedance movement and the reaching of a reversal point (U) are inferred if the amount of the real component sum deviates beyond a predefined extent from the amount of the difference between the real component of the first impedance value (Z, Z0-Z6) used to form the real component sum and the real component of the last impedance value (Z, Z0-Z6) used to form the real component sum.

8. Method according to one of the preceding claims, **characterized in that**
the occurrence of a change of direction of the impedance movement and the reaching of a reversal point (U) are inferred if the real components of two consecutive impedance change vectors (dZ1-dZ5) have different signs.

9. Method according to one of the preceding claims, **characterized in that**
the predefined movement criterion applied to check whether the impedance reveals a directional, continuous impedance movement comprises checking whether the amount of the time derivative of the impedance values (Z, Z0-Z6) lies within a predefined reference interval after the time.

10. Method according to one of the preceding claims, **characterized in that**
the predefined movement criterion applied to check whether the impedance reveals a directional, continuous impedance movement comprises checking whether the amount of the time derivative of the real component and/or the imaginary component of the impedance does or does not change beyond a predefined extent in the case of consecutive impedance values (Z, Z0-Z6).

11. Method according to one of the preceding claims, **characterized in that**

- the predefined movement criterion applied to check whether the impedance reveals a directional, continuous impedance movement comprises checking whether the angle difference between the impedance change vectors (dZ1-dZ5) of temporally consecutive impedance change vectors (dZ1-dZ5) exceeds or falls below a predefined limit, and/or
- the predefined movement criterion applied to check whether the impedance reveals a directional, continuous impedance movement comprises checking whether a simultaneous change in both the sign of the real component and the sign of the imaginary component has occurred in the case of temporally consecutive impedance change vectors (dZ1-dZ5).

12. Method for controlling a protection device, in particular a distance protection device (DSM) which monitors a line to which the electrical impedance is connected,
**characterized in that**
the protection device or at least a protection function of the protection device is controlled at least also through the use of a classification signal (Q) which has been generated according to one of the preceding claims.

13. Method according to Claim 12,
**characterized in that**

the protection device or at least a protection function of the protection device is deactivated as long as the classification signal (Q) indicates an oscillation movement (P).

14. Method according to one of the preceding Claims 12 to 13, **characterized in that**
the protection device or at least a protection function of the protection device is deactivated if the classification signal (Q) indicates a fault (F).

15. Device (20) for generating a classification signal (Q) classifying an electrical impedance,
**characterized in that**
the device (20) is designed in such a way that

- it forms impedance change vectors (dZ1-dZ5) whose direction describes the movement of the impedance in the complex impedance plane and whose length describes the amount of the respective impedance change with temporally consecutive impedance values (Z, Z0-Z6),
- it checks on the basis of the impedance values (Z, Z0-Z6) and/or the impedance change vectors (dZ1-dZ5) whether the impedance shows a directional, continuous impedance movement according to at least one predefined movement criterion,
- in the event of a previously detected directional, continuous impedance movement and in the event of a subsequently detected change of direction of the impedance movement, it infers that a reversal point (U) has been reached and monitors the rotation of the impedance change vectors (dZ1-dZ5) in the area of the reversal point (U) with formation of an angle of rotation measured value ($\varphi$s), and
- it generates a classification signal (Q) indicating a fault (F) if the impedance change vectors (dZ1-dZ5) have rotated in the area of the reversal point (U) through a predefined maximum angle of rotation or through more than the predefined maximum angle of rotation.

**Revendications**

1. Procédé de production d'un signal (Q) de classement classant une impédance électrique,
**caractérisé en ce que**

- on mesure la courbe de l'impédance en fonction du temps, en formant des valeurs (Z, Z0 à Z6) d'impédance,
- on forme avec des valeurs (Z, Z0 à Z6) d'impédance se succédant dans le temps des vecteurs (dZ1 à dZ5) de variation d'impédance, dont la direction décrit le déplacement de l'impédance dans le plan d'impédance complexe et dont la longueur décrit la valeur absolue de la variation respective d'impédance,
- à l'aide des valeurs (Z, Z0 à Z6) d'impédance et/ou des vecteurs (dZ1 à dZ5) de variation d'impédance, on contrôle si l'impédance, suivant au moins un critère de déplacement donné à l'avance, présente un déplacement d'impédance dirigé continuel,
- dans le cas d'un déplacement d'impédance dirigé continuel détecté auparavant et dans le cas d'un changement de direction détecté ensuite du déplacement d'impédance, on en déduit que l'on a atteint un point (U) de rebroussement, et on contrôle la rotation des vecteurs (dZ1 à dZ5) de variation d'impédance dans la partie du point (U) de rebroussement, en formant une valeur ($\varphi$s) de mesure d'angle de rotation et
- on produit un signal (Q) de classement indiquant un défaut (F), si les vecteurs (dZ1 à dZ5) de variation d'impédance ont, dans la partie du point (U) de rebroussement, tourné d'un angle de rotation maximum donné à l'avance ou de plus que l'angle de rotation maximum donné à l'avance.

2. Procédé suivant la revendication 1,
**caractérisé en ce que**
l'angle de rotation maximum donné à l'avance a une valeur comprise entre 240° et 310°, en étant notamment de 270° $\pm$ 5°.

3. Procédé suivant l'une des revendications précédentes, **caractérisé en ce que**
l'on produit aussi un signal (Q) de classement indiquant un défaut (F) lorsque, après avoir atteint le point (U) de rebroussement dans un laps de temps donné à l'avance, on ne constate pas, suivant le au moins un critère de déplacement donné à l'avance, de reprise du déplacement d'impédance dirigé continuel.

4. Procédé suivant la revendication 3,
**caractérisé en ce que**

le laps de temps donné à l'avance est compris entre 20 et 40 périodes de la fréquence du réseau, à laquelle l'impédance électrique est soumise.

5. Procédé suivant l'une des revendications précédentes, **caractérisé en ce que** l'on détermine la valeur ($\varphi$s) de mesure d'angle de rotation en

- déterminant respectivement l'angle, entre deux vecteurs (dZ1 à dZ5) de variation d'impédance se succédant en formant une valeur ($\varphi$1 à $\varphi$5) d'angle et cela en incluant des vecteurs (dZ1 à dZ5) de variation d'impédance dans la partie de déplacement d'impédance dirigé continuel, avant le point (U) de rebroussement et des vecteurs (dZ1 à dZ5) de variation d'impédance derrière le point (U) de rebroussement, et
- déterminant entre les valeurs ($\varphi$1 à $\varphi$5) d'angle se succédant, des différences ($\varphi$2 - $\varphi$1, $\varphi$3 - $\varphi$2, $\varphi$4 - $\varphi$3, $\varphi$5 - $\varphi$4) d'angle et en additionnant les valeurs absolues des différences ($|\varphi$2 - $\varphi$1|, $|$ $\varphi$3 - $\varphi$2|, $|\varphi$4 - $\varphi$3|, $|\varphi$5 - $\varphi$4|) d'angle, et en utilisant la somme des valeurs absolues des différences d'angle comme valeur de mesure d'angle de rotation.

6. Procédé suivant l'une des revendications précédentes, **caractérisé en ce que**

- dans le cas où un déplacement d'impédance continuel dirigé continuel a été détecté, on produit un signal (Q) de classement indiquant un déplacement (P) pendulaire et
- on maintient le signal (Q) de classement indiquant le déplacement (P) pendulaire, à moins que les vecteurs (dZ1 à dZ5) de variation d'impédance tournent dans la partie du point (U) de rebroussement au-delà de l'angle de rotation maximum donné à l'avance ou si, après avoir atteint le point (U) de rebroussement dans le laps de temps donné à l'avance, on ne constate pas de reprise du déplacement d'impédance dirigé continuel.

7. Procédé suivant l'une des revendications précédentes, **caractérisé en ce que**

- on additionne, en formant une somme de parties réelles, les valeurs absolues des parties (dR1 à dR5) réelles d'au moins trois vecteurs (dZ1 à dZ5) de variation d'impédance se succédant et
- à l'apparition d'un changement de direction du déplacement d'impédance et lorsqu'un point (U) de rebroussement est atteint, on déduit que la valeur absolue de la somme des parties réelles s'écarte, au-delà d'une mesure donnée à l'avance, de la valeur absolue de la différence entre la partie réelle de la première valeur (Z, Z0 à Z6) d'impédance mise à profit pour la formation de la somme des parties réelles et la partie réelle de la dernière valeur (Z, Z0 à Z6) d'impédance mise à profit pour la formation de la somme de parties réelles.

8. Procédé suivant l'une des revendications précédentes, **caractérisé en ce que** à l'apparition d'un changement de direction d'un déplacement d'impédance et lorsqu'un point (U) de rebroussement est atteint, on déduit que les parties réelles de deux vecteurs (dZ1 à dZ5) de variation d'impédance se succédant ont des signes inégaux.

9. Procédé suivant l'une des revendications précédentes, **caractérisé en ce que** le critère de déplacement donné à l'avance, à l'aide duquel on contrôle si l'impédance présente un déplacement d'impédance dirigé continuel, comprend un contrôle du point de savoir si la valeur absolue de la dérivée en fonction du temps des valeurs (Z, Z0 à Z6) d'impédance est dans un intervalle de consigne donné à l'avance.

10. Procédé suivant l'une des revendications précédentes, **caractérisé en ce que** le critère de déplacement donné à l'avance, à l'aide duquel on contrôle si l'impédance présente un déplacement d'impédance dirigé continuel, comprend un contrôle du point de savoir si la valeur absolue de la dérivée en fonction du temps de la partie réelle et/ou de la partie imaginaire de l'impédance se modifie ou non, au-delà d'une mesure donnée à l'avance, pour des valeurs (Z, Z0 à Z6) d'impédance se succédant.

11. Procédé suivant l'une des revendications précédentes, **caractérisé en ce que**

- le critère de déplacement donné à l'avance, à l'aide duquel on contrôle si l'impédance indique un déplacement d'impédance dirigé continuel, comprend un contrôle du point de savoir si la différence d'angle entre les vecteurs (dZ1 à dZ5) de variation d'impédance de vecteurs (dZ1 à dZ5) de variation d'impédance se succédant dans le temps est inférieure ou supérieure à une limité donnée à l'avance, et/ou
- le critère de déplacement donné à l'avance, à l'aide duquel on contrôle si l'impédance présente un déplacement d'impédance dirigé continuel, comprend un contrôle du point de savoir si une variation simultanée à la fois du signe de la partie réelle et du signe de la partie imaginaire se produit pour des vecteurs (dZ1 à dZ5) de variation de l'impédance se succédant dans le temps.

12. Procédé de commande d'un dispositif de protection, notamment d'un dispositif (DSM) de téléprotection, qui contrôle une ligne à laquelle est raccordée l'impédance électrique,
**caractérisé en ce que**
on commande le dispositif de protection ou au moins une fonction de protection du dispositif de protection, au moins également en tirant partie d'un signal (Q) de classement, qui a été produit suivant l'une des revendications précédentes.

13. Procédé suivant la revendication 12,
**caractérisé en ce que**
l'on désactive le dispositif de protection ou au moins une fonction de protection du dispositif de protection, tant que le signal (Q) de classement indique un déplacement (P) pendulaire.

14. Procédé suivant l'une des revendications 12 à 13, **caractérisé en ce que**
l'on désactive le dispositif de protection ou au moins une fonction de protection du dispositif de protection, si le système (Q) de classement indique un défaut (F).

15. Dispositif (20) de production d'un signal (Q) de classement classant une impédance électrique,
**caractérisé en ce que**
le dispositif (20) est constitué de manière

- à former avec des valeurs (Z, Z0 à Z6) d'impédance se succédant dans le temps des vecteurs (dZ1 à dZ5) de variation d'impédance, dont la direction décrit le déplacement de l'impédance dans le plan d'impédance complexe et dont la longueur décrit la valeur absolue de la variation respective d'impédance,
- à contrôler à l'aide des valeurs (Z, Z0 à Z6) d'impédance et/ou des vecteurs (dZ1 à dZ5) de variation d'impédance, si l'impédance, suivant au moins un critère de déplacement donné à l'avance, présente un déplacement d'impédance dirigé continuel,
- dans le cas d'un déplacement d'impédance dirigé continuel détecté auparavant et dans le cas d'un changement de direction détecté ensuite du déplacement d'impédance, à déduire que l'on a atteint un point (U) de rebroussement, et à contrôler la rotation des vecteurs (dZ1 à dZ5) de variation d'impédance dans la partie du point (U) de rebroussement, en formant une valeur ($\varphi$s) de mesure d'angle de rotation et
- à produire un signal (Q) de classement indiquant un défaut (F), si les vecteurs (dZ1 à dZ5) de variation d'impédance ont, dans la partie du point (U) de rebroussement, tourné d'un angle de rotation maximum donné à l'avance ou de plus que l'angle de rotation maximum donné à l'avance.

# FIG 1

# FIG 2

FIG 3

FIG 4

FIG 5

FIG 6

# FIG 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2304857 B1
- DE 19746719 C1
- DE 4100646 A1